# EUROPÄISCHE PATENTSCHRIFT

(11) **EP 2 588 649 B1**
(45) Veröffentlichungstag und Bekanntmachung des Hinweises auf die Patenterteilung: **20.04.2016**
(21) Anmeldenummer: 11754824.8
(22) Anmeldetag: 30.06.2011
(51) Int. Cl.: C30B 7/00, C30B 7/02, C30B 29/58

(54) **VORRICHTUNG UND VERFAHREN ZUR KONTROLLE DER KRISTALLISATION VON MAKROMOLEKÜLEN**
APPARATUS AND METHOD TO CONTROL CRYSTALLIZATION OF MACROMOLECULES
DISPOSITIF ET PROCÉDÉ POUR LE CONTRÔLE DE LA CRISTALLISATION DES MACROMOLÉCULES

(30) Priorität: 01.07.2010 DE 102010025842
(43) Veröffentlichungstag der Anmeldung: 08.05.2013
(73) Patentinhaber: Xtal Concepts GmbH, 22527 Hamburg (DE)
(72) Erfinder: BETZEL, Christian, 21369 Schenefeld (DE); HILGENFELD, Rolf, 23562 Lübeck (DE); HILTERHAUS, Dierk, 21394 Kirchgellersen (DE); KLUPSCH, Thomas, 07745 Jena (DE); MÜHLIG, Peter, 07743 Jena (DE); MEYER, Arne, 21079 Hamburg (DE); DIERKS, Karsten, 22453 Hamburg (DE)
(74) Vertreter: Hansen, Jochen
(86) Internationale Anmeldenummer: PCT/DE2011/001393
(87) Internationale Veröffentlichungsnummer: WO 2012/000493

(56) Entgegenhaltungen:
- WO-A1-03/080901
- US-A- 4 919 899
- US-A1- 2001 006 807
- US-A1- 2003 233 978
- US-B2- 7 470 324
- Karsten Dierks ET AL: "Dynamic Light Scattering in Protein Crystallization Droplets: Adaptations for Analysis and Optimization of Crystallization Processes", Crystal Growth & Design, vol. 8, no. 5, 1 May 2008 (2008-05-01), pages 1628-1634, XP055186833, ISSN: 1528-7483, DOI: 10.1021/cg701067r

## Beschreibung

Die Erfindung betrifft eine Vorrichtung und ein Verfahren zur Kontrolle des Kristallwachstums von Makromolekülen, insbesondere von biologischen Makromolekülen.

Eine wesentliche Aufgabe im Bereich der Biochemie und Molekularbiologie besteht in der atomgenauen Aufklärung der dreidimensionalen Struktur von Biomolekülen, insbesondere von Proteinen. Die meisten gegenwärtig vorliegenden Strukturmodelle von Proteinen und anderen Biomolekülen im Auflösungsbereich von 0,25 nm und besser wurden mit Hilfe der Röntgenstrukturanalyse gewonnen. Eine Voraussetzung für die Anwendung dieses Verfahrens ist das Vorliegen von Einkristallen. Der Grad der inneren Ordnung des Einkristalls bestimmt dabei wesentlich die Güte der gewonnen Daten und damit die Genauigkeit der ermittelten Struktur.

Aufgrund der großen Anzahl an Parametern, welche die Kristallisation der Proteine beeinflussen (Konzentration des zu kristallisierenden Materials, Konzentration des Lösungsmittels, Konzentration der Präzipitanten, Konzentration weiterer Hilfsmittel, Änderungen des pH-Wertes, Änderungen der Temperatur, etc...), ist es bis zum heutigen Tage schwer, reproduzierbare Ergebnisse bei der Kristallisation zu erhalten.

Aus dem US-Patent 4,919,899 ist eine Apparatur zur Züchtung von Protein-Einkristallen bekannt. Es wird hier nach der "hanging Drop"-Methode vorgegangen, es erfolgt eine Regelung der Konzentration der Tropfenkomponenten durch Verdunstung oder Hinzufügen des Lösungsmittels. Eine automatisierte Optimierung der Kristallisationsbedingungen ist vorgesehen.

Die dynamische Kontrolle des Kristallwachstums bei Proteinen ist auch aus US2001006807 A1 bekannt. Hier wird die Konzentration des Lösungsmittels über die Temperatur und den Gasstrom geregelt.

Aus der US 2003/0233978 A1 ist ein Verfahren und eine Anordnung bekannt, mittels derer eine Kristallisation von Biomakromolekülen realisierbar sein soll. Wie die bereits zuvor genannten Druckschriften arbeitet dieses Verfahren bzw. die Anordnung ebenfalls nach dem "trial and error"-Prinzip, wobei ergänzend zu dem bisherigen bekannten Stand der Technik zusätzlich eine dynamische Lichtstreuung verwendet wird. Im Wesentlichen sind zwei durch eine semipermeable Membran aneinander gekoppelte Kammern vorgesehen, um Kristalle wachsen zu lassen. Hierbei wird versucht, eine Kristallisation in der ersten Kammer über eine Veränderung der Lösung mit Hilfe der semipermeablen Membran und der weiteren Kammer zu realisieren, wobei zusätzlich versucht wird über eine dynamische Lichtstreuungs-Messung bzw. sogar über eine mikroskopisch visuelle Beobachtung den Kristallisationsvorgang aktiv zu steuern. Da das Hinzufügen bzw. Austauschen von Flüssigkeiten in der weiteren Kammer zur Veränderung der Konzentrationen in der ersten Kammer und das zeitlich intensive Diffundieren durch die semipermeable Membran Zeit in Anspruch nehmen, sind das Verfahren und die Anordnung nicht zum kontrollierten Abfahren eines vorgegebenen Phasendiagramms geeignet. Eine Bestimmung der Konzentration ist nicht in der Kammer, in der die Kristallisation stattfindet, möglich und zudem ist unbekannt, wann genau ein Ausgleich durch die semipermeable Membran hindurch zwischen den Kammern stattgefunden hat.

Aus der Druckschrift WO 03/080901 A1 ist ein Verfahren nach dem klassischen Ansatz zur Herstellung von makromolekularen Kristallen, nämlich zur Kristallisation eines in einem Lösungsmittel gelösten Makromoleküls sowie eine Vorrichtung zur Durchführung dieses Verfahrens offenbart, bei dem ein den Stoff enthaltendes Lösungsmittelvolumen in eine Kammer mit voreingestellten Bedingungen eingebracht wird, zu dem ein Präzipitant hinzugegeben wird, wobei das Lösungsmittel verdampfen gelassen wird und gleichzeitig ein Beobachten von Strukturänderungen mittels dynamischer Lichtstreuung erfolgt und dieses in einem Phasendiagramm zugeordnet wird, wobei Kristallisationskerne ausgebildet werden und das den Stoff und den Präzipitanten enthaltende Lösungsmittelvolumen in einem metastabilen Zustand durch Zugabe von Lösungsmittel und/oder Makromoleküllösung / Verdampfenlassen des Lösungsmittels überführt und aufrechterhalten wird bis wenigstens ein Kristall vorbestimmter Größe ausgebildet ist.

Allen bekannten Methoden zur reproduzierbaren und automatisierbaren Kristallisation ist gemein, dass hier durch Beeinflussung eines Parameters ein festgelegter Weg im Phasendiagramm beschritten wird.

Insbesondere wasserunlösliche Proteine, wie die für die Wirkstoffforschung sehr interessanten Membranproteine sind der reproduzierbaren und automatisierbaren Kristallzüchtung nicht zugänglich.

Es ist Aufgabe der Erfindung, die Kristallisation von Biomolekülen, insbesondere von Proteinen zu verbessern. Des Weiteren ist es Aufgabe der Erfindung, eine Vorrichtung und ein Verfahren zur Verfügung zu stellen, die es ermöglicht, reproduzierbar und automatisierbar Kristalle aus biologischem Material zu züchten. Des Weiteren ist es Aufgabe der Erfindung, eine Vorrichtung und ein Verfahren zur Verfügung zustellen, die es ermöglicht reproduzierbar und automatisierbar Kristalle von biologischem Material zu züchten, bei dem dieses bisher nicht möglich ist. Des Weiteren ist es Aufgabe der Erfindung eine Vorrichtung und ein Verfahren zur Verfügung zu stellen, die es ermöglicht, reproduzierbar und automatisierbar Kristalle von biologischem Material zu züchten, ohne dabei von Versuch und Irrtum abhängig zu sein.

Überraschenderweise hat sich gezeigt, dass es möglich ist, die Kristallisation von biologischen Makromolekülen auf submikroskopischer Ebene zu beobachten und zu beeinflussen und damit die Möglichkeit zu schaffen, nahezu jeden Punkt im Phasendiagramm zu erreichen und dort auch zu verweilen, wenn eine in den Ansprüchen beschriebene Vorrichtung und Verfahren angewendet wird. Die Unteransprüche geben vorteilhafte Ausgestaltungen der Erfindung wieder.

Das erfindungsgemäße Verfahren umfasst die folgenden Schritte:
a. Aufbringen eines Proben-Tropfens einer Lösung des zu Kristallisierenden Materials auf den Probenhalter in einer Prozesskammer
b. Einstellung und Konstanthalten der Temperatur, Luftfeuchtigkeit und Gaszusammensetzung in der Prozesskammer
c. Konstanthalten des Tropfengewichtes vor der Zugabe von Präzipitant (e) durch Zugabe von Lösungsmittel
d. Messung der Größenradien der Proteinmoleküle im Probentropfen nach dem Aufbringen des Probentropfens und während der folgenden Verfahrensschritte mittels der DLS
e. Zugabe von Präzipitantlösung in den Probentropfen und Abnahme der Probenmasse durch geregelte Lösungsmitteldampfdiffusion
f. Eintritt in die Nukleationszone sobald ein bestimmtes Konzentrationsverhältnis von Protein und Präzipitant im Probenvolumen vorliegt
g. Entscheidung auf Grund der Ergebnisse der kontinuierlichen DLS-Messung ob Entweder Verringerung der Anzahl der Nuklei durch Zugabe von Lösungsmittel
   Oder Zugabe von weiterem Präzipitant um die Anzahl der Nuklei zu erhöhen
h. Verlassen der Nukleationszone auf zwei Wegen:
   A: Durch Zugabe von Lösungsmittel und/oder Proteinlösung
   B: Durch die Verminderung der Konzentration freier Proteinmoleküle in Folge der Nukleation
   A und B sind von einer Abnahme der Streulichtintensität begleitet
i. Erreichen eines gewünschten Punktes innerhalb der metastabilen Zone im Phasediagramm, erkennbar an einem Kristallwachstum, durch dosierte Zugabe von Lösungsmittel, um die Konzentrationsverhältnisse von Protein und Präzipitant konstant zu halten.
j. Halten des Systems in der metastabilen Zone bei Auftreten einer Verlangsamung des Kristallwachstums durch entweder
   Zugabe von Protein um die Proteinkonzentration zu erhöhen
   oder
   Verringerung der Lösungsmittelzugabe, durch die kontinuierlich stattfindende
   Verdampfung kommt es so zu einer Erhöhung der Protein- und Präzipitantenkonzentration.
k. Zugabe einer Gefrierschutzlösung Statt des Lösungsmittels ein Gemisch aus Lösungsmittel und Gefrierschutzlösung der Probe hinzugeben in einer Rate, die den Lösungsmittelverlust in Folge der Dampfdiffusion kompensiert (konstantes Gewicht), wobei sich nach und nach eine Anreicherung der Gefrierschutzlösung einstellt.
l. Entnahme der Kristalle

Die erfindungsgemäße Vorrichtung enthält die folgenden Komponenten:
- Automatisierte Probenpipettiervorrichtung zur Tropfenhandhabung
- Automatisierter Probenwechsler
- Optische Vorrichtung (mikroskopische Auflösung) z. B. Mikroskop mit Kamera zur Beobachtung der in der Probe ablaufenden Prozesse und zur Bestimmung der Kristallgrößen sowie zur Positionierung der berührungslosen Mess- und Dosierverfahren.
- Dynamische Lichtstreuung (DLS) zur Bestimmung der Molekülgrößenverteilung mit submikroskopischer Auflösung
- Statische Lichtstreuung zur absoluten Streulichtintensitätsmessung
- Wärmestrahlungssensor zur Bestimmung von Reaktionsenthalpien
- Mikrowaage zur präzisen Bestimmung aller Molaritäten bzw. deren Veränderungen
- Mikrodosiervorrichtung mit mehreren Kanälen für:
   - Wasser
   - Präzipitant
   - Pufferlösung
   - Proteinlösung
   - Additive
   - Gefrierschutzlösung
   - Quervernetzung
   - Liganden
   - Detergentien
   - Weitere Substanzen nach Bedarf
- Feuchtigkeitsregelung
- Temperaturregelung
- Regelung der Atmosphärenzusammensetzung
- Vorrichtung zur Zufügung von Impfkristallen

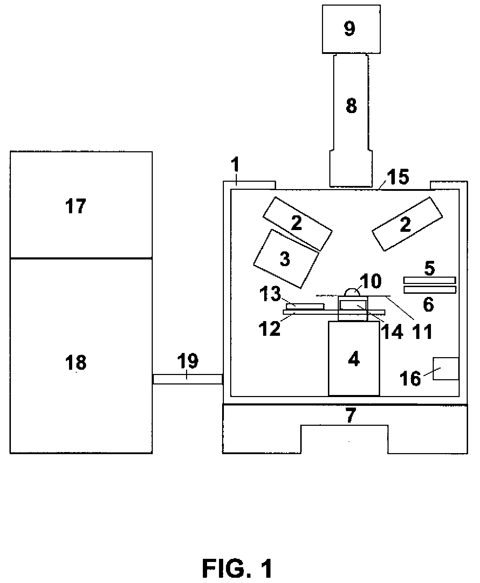

Eine schematische Fig. der erfindungsgemäßen Vorrichtung findet sich in Fig. 1

Die Komponenten der erfindungsgemäßen Vorrichtung (X-tal Controller) sind im Einzelnen:
- Ein Mikroskop, oder eine sonstige optische Vorrichtung, vorzugsweise ausgestattet mit einer CCD-Kamera oder einem anderen bildgebenden System, zur Beobachtung der in der Probe ablaufenden Prozesse und der Vermessung der Kristalle Fig. 1 (8, 9). Die Bestimmung der Kristallwachstumsrate erfolgt über die optische Vorrichtung aus Mikroskopobjektiv und CCD-Kamera. Es kann zu einem gegebenen Zeitpunkt die Umrisslinie des wachsenden Kristalls vermessen und gegen die Zeit aufgetragen werden. Aus der erhaltenen Steigung der Kurve lässt sich das Kristallwachstum ermitteln. Andere Möglichkeiten der Kristallvermessung sind z.B. eine Volumenmessung oder manuelle Messmethoden.
   - Eine Beleuchtungsvorrichtung über eine LED oder jede andere Art von Lichtquelle.
   - Eine Waage, vorzugsweise mit einer Wägegenauigkeit von 0,1 µg oder auch jede andere zur Massebestimmung geeignete Vorrichtung. Sie dient der Bestimmung der Konzentrationen bzw. Konzentrationsverhältnisse aller an der Reaktion beteiligten Stoffe. Dies ist insbesondere wichtig beim Hinzudosieren von Substanzen, die zur Kristallisation benötigt werden, sowie zur Verfolgung der Verdunstung des Wasseranteils der Probenlösung Fig. 1 (4) Auf diese Weise ist die Bestimmung der Verdunstungsrate der Probe genauer als dies beispielsweise durch optische Verfahren möglich ist.
   - Mehrere Dosiersysteme, vorzugsweise Mikrodosiersysteme mit einem Beförderungsvolumen von 30 - 300 pL pro Hub. Fig. 1 (2) oder jedwede andere Vorrichtung, die einen definierten Substanzeintrag in die Probe gestattet.
   - Eine Vorrichtung zur Messung der Größenverteilung und/oder Form der in der Lösung enthaltenen Partikel. Dieses kann bevorzugt unter Ausnutzung von Lichtstreuverfahren geschehen (Fig. 1 (3)). Besonders bevorzugt ist die Verwendung eines Verfahrens der dynamischen Lichtstreuung (DLS), bei dem das Streuvolumen direkt im Probenvolumen liegt. Die Verwendung eines DLS-Verfahrens, bei dem die Komponenten in einer Rückstreugeometrie angeordnet sind, erlaubt einen besonders kompakten Messaufbau. Ein besonderer Vorteil von DLS ist die nichtinvasive Partikelgrößenverteilungsbestimmung welche auch in sehr kleinen Volumina von weniger als 10µL bevorzugt weniger als 1 µL möglich ist.
   - Eine Prozesskammer, in diesem Fall mit einer Vorrichtung zur Regulation der relativen Feuchte auf 1%, besser 0,1% besonders bevorzugt 0,01%, der Temperatur auf 0,1 °C und der Gaszusammensetzung ausgerüstet ist. Die Temperaturregelung kann über beliebige Wärme- und Kälteerzeuger erfolgen, bevorzugt ist der Einsatz von Peltierelementen. Abb 1 (1)
   - Eine Vorrichtung zur Messung der Wärmeänderung innerhalb der Probe wird im konkreten Fall durch einen berührungslosen, pyroelektrischen Thermosensor realisiert, der die bei der Reaktion in der Probe erfolgenden Wärmeänderungen erfasst Fig. 1 (14).
   - Ein Untergestell, in diesem Fall ein schwingungsgedämpftes Untergestell Fig. 1 (7).
   - Alternativ, aber nicht zwingend ist die Apparatur über das Internet oder Ethernet fernbedienbar, alternativ, aber nicht notwendigerweise werden die Daten in einer Datenbank abgelegt.

Als Detergenzien, welche insbesondere bei der Kristallisation von Membranproteinen eine wichtige Rolle spielen, kommen ionische oder nichtionische Detergenzien in Frage. Bevorzugt finden Detergenzien mit einer gesättigten Alkyl-Gruppe Anwendung. Solche Detergenzien können Alkyl-beta-D-glucoside, Alkyl-beta-D-thioglucoside, Alkyl-beta-D-maltoside insbesondere mit Heptyl-, Octyl-, Nonyl-, Decyl- al Alkylgruppen sein. Im Einzelnen können auch Dimethylaminoxid, Oligo-oxyethylen, n-Tridecyl-β-D-Maltopyranosid, n-Dodecyl-β-D-Thiomaltopyranosid, ANAPOE®-C12E9, Octaethylen-Glycol Monodedecyl Ether, ANAPOE®-C12E8, ANAPOE®-C13E8, n-Dodecyl-α-D-Maltopyranosid, n-Dodecyl-β-D-Maltopyranosid, CYMAL®-7, ANAPOE®-X-114, ANAPOE®-C12E10, n-Undecyl-β-D-Thiomaltopyranosid, ANAPOE®-X-100, Sucrose Monododecanoat, CYMAL®-6, n-Undecyl-α-D-Maltopyranosid, n-Undecyl-β-D-Maltopyranosid, CYCLOFOS™-7, Pentaethylenglycol Monodecylether, n-Decyl-β-D-Maltopyranosid, ANAPOE®-C10E6, n-Decyl-β-D-Maltopyranosid, ANAPOE®-C10E9, n-Decyl-β-D-Maltopyranosid, CYMAL®-5, n-Nonyl-β-D-Thiomaltopyranosid, Dimethyldecylphosphinoxid, n-Nonyl-β-D-Maltopyranosid, n-Nonyl-β-D-Glucopyranosid, CYMAL®-4, Tetraethylenglycol Monomethylether, n-Octyl-β-D-Thiomaltopyranosid, Hexaethylenglycol Monooctylether, ANAMEG®-7 als Detergenzien eingesetzt werden.

Als Präzipitanten kommen organische Verbindungen, sowie organische- und anorganische Salze in Frage. Als organische Verbindungen können beispielsweise Polyethylenglycol, Isopropanol oder Dimethylsulfoxid eingesetzt werden, als anorganische Salze kommen u.a. Natriumchlorid, Ammoniumsulfat oder Lithiumchlorid in Frage. Mögliche organische Salze sind u.a. Natriumacetat, Natriumcitrat oder Natriumtartrat.

Als Liganden kommen alle Arten von Naturstoffen bis hin zu Proteinen, sowie alle Arten synthetischer Verbindungen in Frage.

Es können Additive eingesetzt werden, welche die die Kristallisation des Proteins positiv beeinflussen. Diese können beispielsweise als Antioxidantien (Ascorbinsäure, Lecitin, Zinn-II-Chlorid), Amphiphile (1,2,3 Heptan-triol, Benzamindin) oder auch divalente Metallionen (Magnesiumchlorid Calciumchlorid oder acetat) sein.

Zur Quervernetzung (Quervernetzungsreagenzien) können Substanzen eingesetzt werden, die zwei Polymere miteinander verbinden. Hierbei können die Verbindungen kovalent- oder ionischen Charakter aufweisen. Beispiele sind: 1-Ethyl-3-(3-dimethylaminopropyl)carbodiimid (EDC), Succinimidyl-4-[N-maleimidomethyl]cyclohexan-1-carboxylat {SMCC}, (Dithiohis[succinimidylpropionat]) (DSP).

Als Gefrierschutzmittel kommen bevorzugt Glycerin, PEG 200-600, Glucose, Inositol, Ethylenglycol und Isopropanol in Frage.

Als Puffersubstanzen können alle hierfür bekannten Verbindungen eingesetzt werden dieses sind z. B. Tris(hydroxymethyl)-aminomehtan (TRIS), Phosphatpuffer (NaH₂PO₄ + Na₂HPO₄), 4-(2-Hydroxyethyl)-1-piperazinethansulfonsäure (HEPES) und 2-(*N-*Morpholino)ethansulfonsäure (MES).

Das erfindungsgemäße Verfahren stützt sich auf die Gewinnung von Information aus dem Tropfen und der Verwendung dieser Information zum gezielten Eingriff in die Zusammensetzung des Kristallisationsansatzes durch Zugabe oder Entfernung von Substanzen. Durch die Messung der Gewichtsänderung über eine Feinwaage ist eine Quantifizierung der Einzelkomponenten im Tropfen möglich.

Die Präzipitantenkonzentration kann sowohl erhöht, als auch erniedrigt werden. Dies geschieht durch Zugabe von Präzipitantenlösung über das Mikrodosiersystem oder durch Verdampfung im Fall der Konzentrationserhöhung. Verringerung der Präzipitantenkonzentration erfolgt durch Zugabe von Wasser bzw. einer Mischung aller übrigen Komponenten.

Die Anordnung gestattet darüber hinaus weitere Substanzen der Probe hinzuzufügen, um chemische Reaktionen hervorzurufen.

Eine weitere Anwendung ist die Zugabe von Stoffen, die eine Gefrierpunktserniedrigung der Mutterlösung hervorrufen. Dies ist eine wichtige Anwendung im Bereich der Proteinkristallisation. Die Gefrierschutzlösung verhindert die Bildung von Wassereiskristallen. Diese Behandlung ist u. U. notwendig, da die Diffraktionsexperimente üblicherweise bei 100 K durchgeführt werden, um Strahlenschäden möglichst gering zu halten.

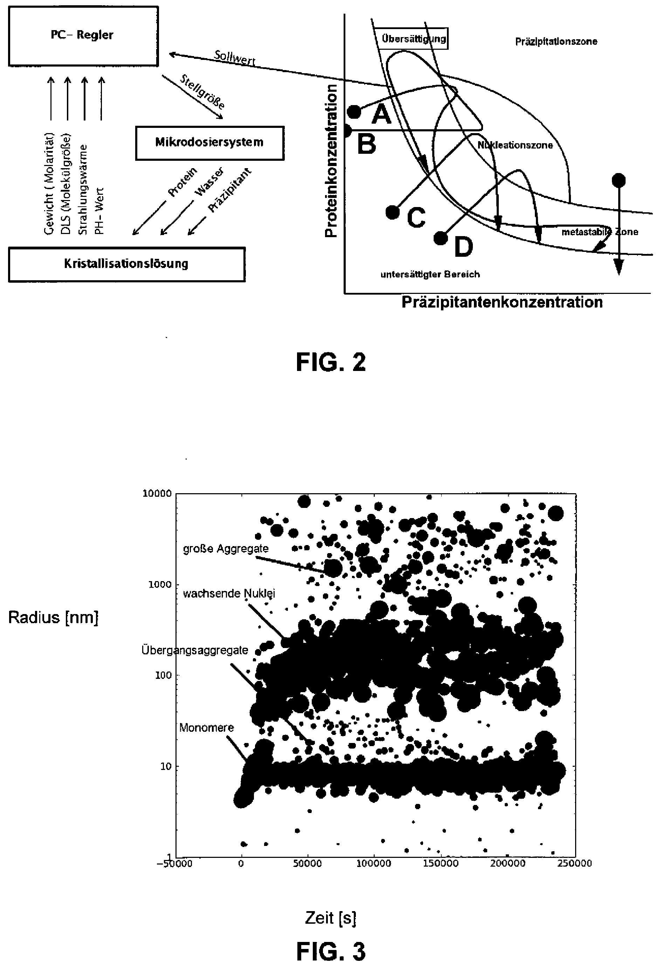

Das Phasendiagramm zeigt die Existenzbereiche der Phasen bzw. Aggregatzustände eines Stoffes oder eines Stoffgemisches in Abhängigkeit thermodynamischer Parameter. In Fig. 2 ist die Proteinkonzentration gegen die Konzentration an Präzipitant aufgetragen. Die Bildung einer festen Phase durch den Zusammenschluss von frei beweglichen Molekülen in Lösung ist ein klassisches Beispiel für einen Phasenübergang, bei dem es sich um eine physikalische Diskontinuität handelt. Im Fall der Kristallisation stellt diese Diskontinuität die Zusammenlagerung einer Teilmenge gleichartiger Moleküle in geordneter Form (Nukleus) innerhalb einer Lösung dar. Ein solcher Nukleus veranlasst weitere Moleküle sich in identischer Weise anzulagern (entstehender Kristall) und so den Nukleus zu vergrößern. Kristallisation findet in übersättigten Lösungen statt und ist beendet sobald die Konzentration der gelösten Moleküle den Sättigungszustand erreicht.

Das Kristallwachstum stellt ein zentrales Ziel des Eingriffs in das Kristallisationssystem dar. (Solange die Kristalle wachsen und keine neuen Kristalle hinzukommen hat man alles richtig gemacht.) Ein Kristallwachstum bei konstanter Kristallanzahl erfolgt nur innerhalb der metastabilen Zone im Phasendiagramm. In der Nukleationszone erfolgt zwar ebenfalls ein Kristallwachstum, allerdings nimmt durch anhaltende Nukleation auch die Anzahl der Kristalle stetig zu. Im untersättigten Bereich bleibt die Anzahl der Kristalle konstant aber es findet auch kein Kristallwachstum statt. Mitunter kann sogar ein Schrumpfen der Kristalle beobachtet werden.

Die Ergebnisse der DLS-Messung zeigen, dass eine enorme Anzahl der Nuklei in einer breiten Größenverteilung in der Mutterlösung vorliegt, bevor Kristalle aus einer solchen Lösung wachsen (Fig. 3). DLS zeigt darüber hinaus die Abhängigkeit der Größenzunahme dieser Aggregate vom Konzentrationsverhältnis des Präzipitanten und des Proteins. Somit ist es möglich gezielt und direkt im Phasendiagramm zu navigieren und bereits vor der Bildung der großen Aggregate Einfluss zunehmen. Die Bildung der großen Aggregate ist somit nicht mehr auf Versuch und Irrtum aufgebaut, sondern kann gezielt gesteuert werden.

Die Durchführung eines Kristallisationsexperimentes zur Erzeugung von Kristallen biologischer Makromoleküle beginnt stets mit der Probenaufgabe. Bei der Probe handelt es sich um einen Tropfen wässriger Proteinlösung in einem Volumen zwischen 1 und 100 µl. Die Probe wird auf einen Probenhalter aufpipettiert oder mit einer dafür vorgesehenen Dosiervorrichtung aufgebracht. Der Probenhalter befindet sich in der Wägeposition der Ultrafeinwaage und gestattet den Laserstrahl zur dynamischen Lichtstreuung (DLS) in die Probe zu richten. Gleichzeitig wird die Probe durch eine Mikroskop-Kameraoptik beobachtet.

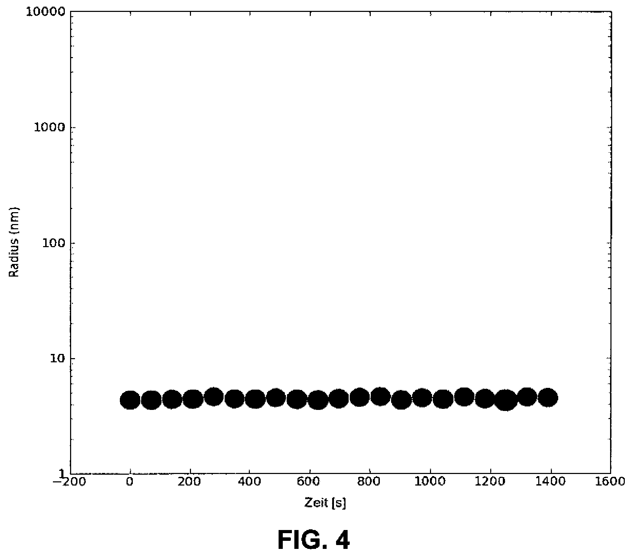

Die Position der Probe gestattet das Hinzudosieren von Lösungsmittel durch eine Mikrodosiervorrichtung in winzigen Tropfen (~30 pl), um einen stetigen Verlust von Lösungsmittel aus dem Tropfen durch Verdampfung auszugleichen. Alle Komponenten befinden sich in der Temperatur- und Luftfeuchtigkeits- und gaszusammensetzungskontrollierten Prozesskammer. Eine durch DLS-Messung erhaltene Radienverteilung der Proteinmoleküle in Lösung zu Beginn eines Experiments ist in Fig. 4 dargestellt.

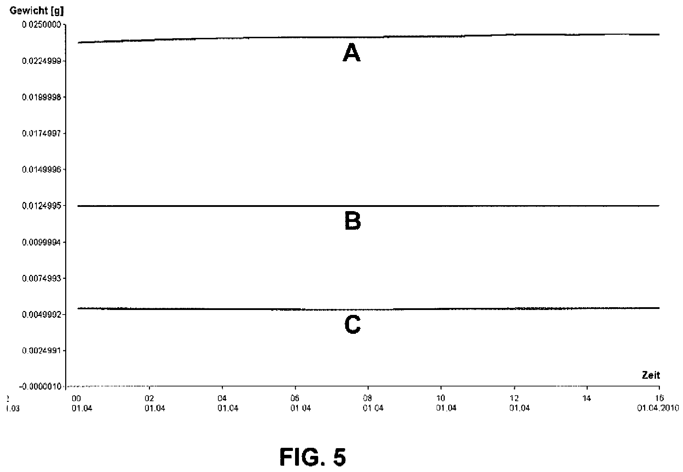

Die DLS-Ausgangsmessung dient der Vergewisserung, ob die Probe keine störenden Partikel enthält, wie Proteinaggregate oder feste Verunreinigungen die sowohl die Messung als auch die Kristallisation beeinträchtigen können. Während dieser DLS-Ausgangsmessung wird das Gewicht der Probe durch die Mikrodosiervorrichtung konstant gehalten (Fig. 5, B). Darüber hinaus werden die Parameter relative Luftfeuchte (A) und Lufttemperatur (C) in der Prozesskammer auf bestimmten Werten gehalten.

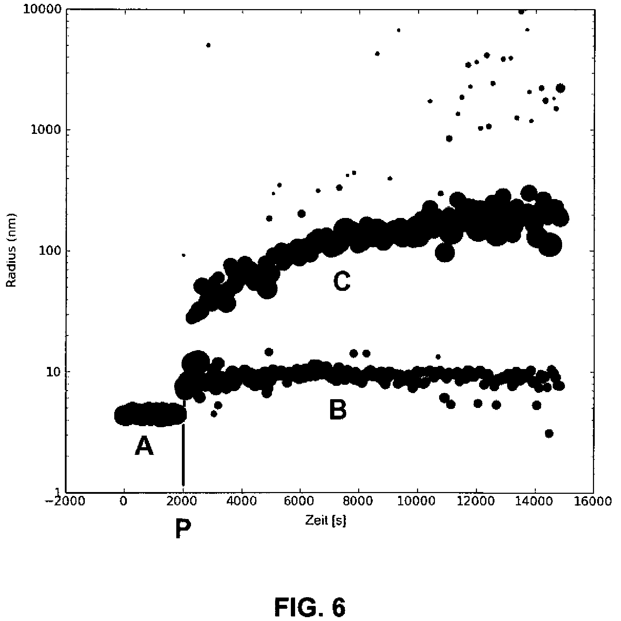

Stellt sich bei der DLS-Ausgangsmessung die Probe wie in Fig. 4 - und somit als für die Kristallisation geeignet dar, kann mit dem eigentlichen Kristallisationsexperiment begonnen werden. Üblicherweise erfolgt die Kristallisation von biologischen Makromolekülen durch die Zugabe einer Substanz (Präzipitant), die mit den gelösten Proteinmolekülen um das Hydratwasser konkurriert und dadurch Wechselwirkungen zwischen den Proteinmolekülen untereinander begünstigt. Wechselwirkungen von Proteinmolekülen untereinander führen in der Regel zu einer Zusammenlangerung der Proteinmoleküle die anschließend als Nuklei vorliegen, deren Radius durch DLS gemessen wird. In Abhängigkeit der Menge an zugegebenen Präzipitanten findet diese Reaktion in unterschiedlichen Ausprägungen statt. Fig. 6 zeigt eine DLS-Messung mit dem Protein vor der Präzipitantenzugabe (A) der Präzipitantenzugabe zum Zeitpunkt (P) nach 2000 s, des veränderten Peaks für das Protein, (B) und der Nuklei (C).

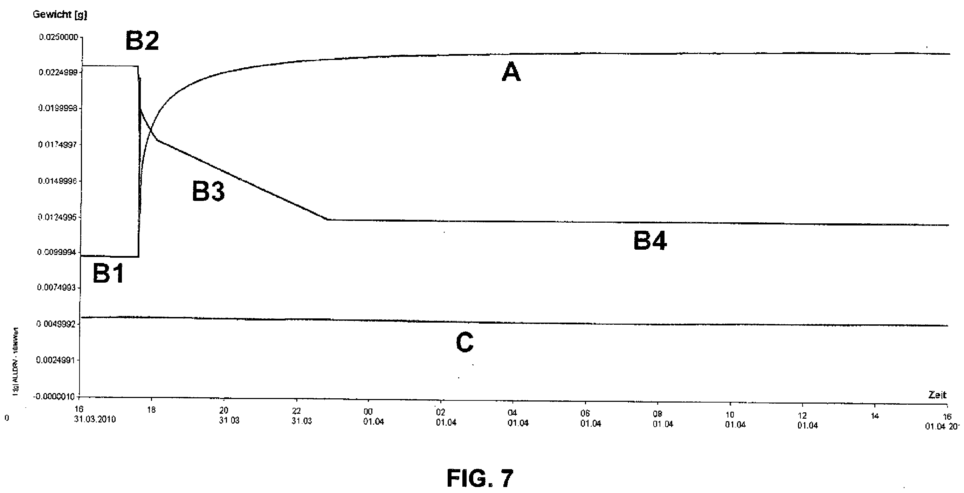

Die Menge an zugegebenen Präzipitanten kann anhand der Gewichtskurve abgelesen werden. Fig. 7 zeigt die zugehörige Gewichtskurve (B) zu Fig. 6. B1 entspricht dem Zeitraum 0-2000s aus Fig. 6. Durch die frühzeitige Erkennung der Nukleation besteht die Möglichkeit die Nukleationsreaktion zu einem sehr frühen Zeitpunkt zu beeinflussen, d. h. durch Zugabe von Lösungsmittel oder Präzipitant abszuschwächen oder zu verstärken.

Fig. 7, B2 stellt den Gewichtszugewinn durch Präzipitantenzugabe dar. Fig. 7, B3 stellt die Phase der Nukleation dar.

Der Einsatz der Ultrafeinwaage gestattet die Berechnung der Konzentrationsverhältnisse in der Probe während der Phase B3 aus Fig. 7. In Folge der Verdampfung des Lösungsmittelanteils ändern sich die Konzentrationsverhältnisse laufend. Fig. 7, A stellt die relative Luftfeuchte, C die Lufttemperatur in der Prozesskammer dar.

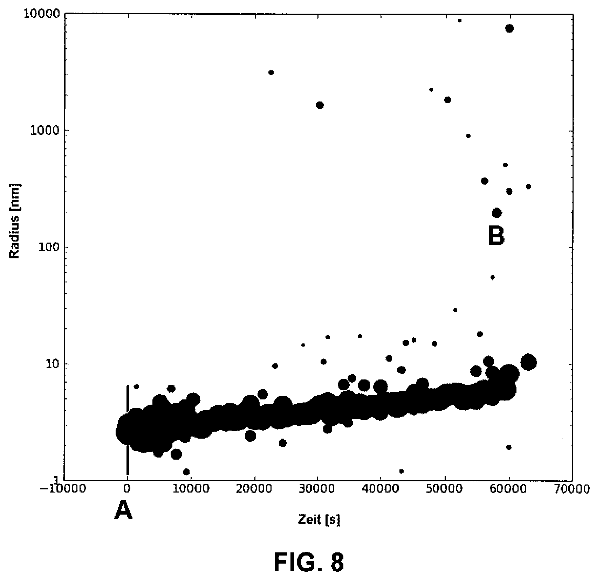

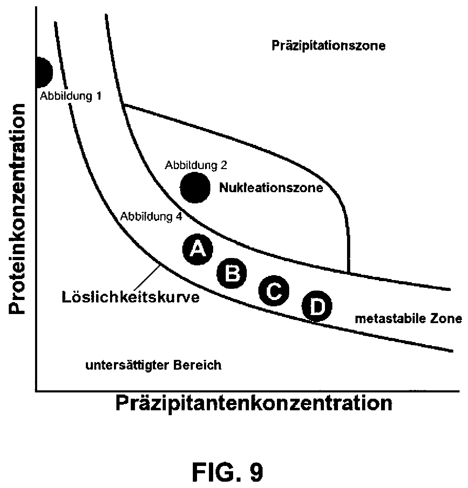

Die Intensität der Nukleation hängt u. a. von den Konzentrationsverhältnissen der Komponenten und von dem eingesetzten Protein ab. Fig. 8 zeigt dies am Beispiel eines anderen Proteins: A: Zugabe des Präzipitanten zum Zeitpunkt 0 s; B: eintretende Nukleation nach 60.000 s.

Die fortlaufende Kristallisation wird durch die Mikroskopoptik beobachtet. Sobald die Kristalle ausgewachsen sind, können sie der Apparatur entnommen werden.

Die DLS-Messungen sowie gemessenen Konzentrationsverhältnisse der in der Probe befindlichen Komponenten, die sich durch die Gewichtskurven berechnen lassen, erlauben eine Zuordnung der Positionen im Phasendiagram. In Fig. 4 und 5 liegt eine bestimmte Proteinkonzentration vor, während die Präzipitantenkonzentration 0 beträgt. Durch Zugabe des Präzipitanten wird die Proteinkonzentration gesenkt und die Präzipitantenkonzentration in der Probe auf einen bestimmten Wert gehoben. Während der Nukleationsphase und des anschließenden Kristallwachstums nimmt die Proteinkonzentration im Tropfen ab, da die Kristalle Proteinmoleküle aus der Lösung adsorbieren und dadurch die Proteinkonzentration verringern. Die Präzipitantenkonzentration nimmt aufgrund der Lösungsmitteldampfdiffusion langsam zu. Das fortschreitende Kristallwachstum kennzeichnet die Position der metastabilen Zone im Phasendiagramm. Das Kristallwachstum ist beendet, sobald im Phasendiagramm die Löslichkeitskurve erreicht ist.

Eine schematische Darstellung des erfindungsgemäßen Verfahrens findet sich in Fig. 2. A, B: Das Verfahren gestattet einen vordefinierten Weg im Phasendiagramm automatisch zu durchlaufen. Dies geschieht sowohl durch die Zugabe von Lösungsmittel als auch durch die Zugabe von Protein- und Präzipitantenlösung. Darüber hinaus kann das System diesen Weg variieren, wenn die DLS Daten oder die Daten von sonstigen Sensorsystemen dies nahe legen. Das ist besonders nützlich in den Fällen, in denen das Phasendiagramm nicht genau bekannt ist. Die Situation, dass die Protein und Präzipitantenkonzentration so hoch ist, dass es zur Ausfällung des Proteins kommt, kann durch das Verfahren vermieden werden (B).

C, D: Lösungsmitteldampfdiffusion in einem herkömmlichen Kristallisationsexperiment. Hierbei nimmt sowohl die Protein, als auch die Präzipitantenkonzentration im selben Verhältnis zu, bis die Bildung von Nuklei in der Nukleationszone einsetzt. Durch das Wachstum der sich bildenden Kristalle wird das Protein aus der Lösung entfernt, wodurch die Proteinkonzentration abnimmt.

Durch die Messung der Gewichtsänderung ist die Etablierung eines geschlossenen Regelkreises möglich. Über eine Rückkoppelung ist es möglich, bestimmte Konzentrationsverhältnisse über lange Zeiträume aufrecht zu erhalten oder bestimmte Konzentrationsverhältnisse zu erzielen.

Mit diesem Verfahren ist es möglich, im Phasendiagramm hin und her zu manövrieren oder an bestimmten Positionen zu verweilen, die zum Beispiel für ein optimales Wachstum eines Kristalls geeignet sind.

Die dynamische Lichtstreuung ermöglicht die Messung der Größenverteilung der Partikel in der Probe. Bei der Kristallisation unterscheidet man prinzipiell zwei Schritte: 1. die Keimbildung (Nukleation) und 2. das Kristallwachstum. Beide Schritte erfolgen bei richtig gewählten Bedingungen in einem Bereich des Phasendiagramms, der als übersättigte Lösung bezeichnet wird. Nuklei sind kleine Partikel, deren Größenverteilung und auch Menge in konkreten Fall durch Lichtstreuungsmessung ermittelt wird.

Die Nukleationszone weist in der Regel einen höheren Übersättigungsgrad auf als der Wachstumsbereich, der auch als metastabile Zone bezeichnet wird. Zur Nukleation müssen die Konzentrationen des Präzipitanten höher sein als in der metastabilen Zone. Unter diesen Bedingungen findet jedoch auch ein schnelles Wachstum der Nuklei statt, und es besteht die Gefahr, dass zahlreiche, jedoch sehr kleine Kristalle entstehen.

Für die Röntgenstrukturanalyse besteht jedoch ein Interesse an möglichst großen Einkristallen (ca. 0.5 mm Kantenlänge). Das bedeutet für das Experiment, dass man sich zwar recht schnell der Nukleationszone annähern, sich aber nicht zu lange in diesem Konzentrationsbereich aufhalten darf, so dass möglichst wenige Nuklei entstehen. Durch hinzufügen von Lösungsmittel in die Probe wird die Nukleationszone wieder verlassen, aber nur soweit, bis die metastabile Zone erreicht ist. Unter diesen Bedingungen werden anschließend die Konzentrationsverhältnisse von Protein und Präzipitant lange genug konstant gehalten, bis die Kristalle ihre maximale Größe erreicht haben.

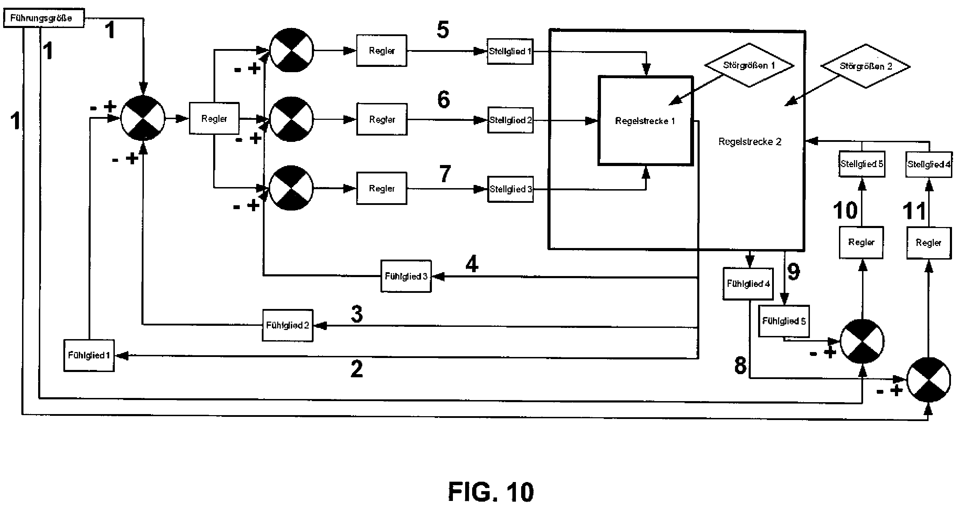

Ein Fließschema zur erfindungsgemäßen automatisierbaren Züchtung von Kristallen findet sich in Fig. 10.

In einem kybernetischen Regelkreis kann die erfindungsgemäße Vorrichtung (X-tal Controller) mit Hilfe der diagnostischen Sensoren und des Mikrodosiersystems die molekulare Zusammensetzung der Kristallisationslösung genau regeln. Es ist erstmals möglich, sich an jedem Punkt des Phasendiagramms beliebig lange aufzuhalten und zu jedem Punkt zu navigieren. Das Phasendiagramm wird also nicht nur in einer Richtung mehr oder minder geschwindigkeitskontrolliert durchlaufen, wie dieses bei den zum Stand der Technik gehörenden Verfahren der Fall ist. Es ist somit möglich, die Kristallisation gezielt zu steuern und nicht von Versuch und Irrtum abzuhängen. Im Folgenden werden die Bezugszeichen zur Fig. 10 sowie die Funktionsweise genauer erläutert.
- Führungsgrößen: werden von außen vorgegebenen und betreffen Werte für die Molaritätsveränderung in Abhängigkeit der Zeit oder Veränderung der Radienverteilung in Abhängigkeit der Zeit, beispielsweise der beabsichtigte Weg im Phasendiagramm.
- Störgrößenl Verdampfung von Lösungsmittel, Wärmeabfluss aus der Probe etc.
- Störgrößen 2: Temperatur- und Feuchtigkeitsschwankungen der Umwelt die Einfluss auf den Innenraum der Prozesskammer ausüben sowie Schwankungen der Gaszusammensetzung aufgrund der Leckrate der Prozesskammer.
- Fühlglied 1 DLS Messapparatur zur Bestimmung des Istwertes der Radienverteilung
- Fühlglied 2 Gewichtsänderung zur Bestimmung des Istwertes der Molaritäten
- Fühlglied 3 Thermosensor zur Feststellung des Istwertes der Temperatur in der Probe
- Fühlglied 4 Feuchtigkeitssensor zur Feststellung des Istwertes der Luftfeuchtigkeit im Innern der Prozesskammer
- Fühlglied 5 Temperatursensor zur Feststellung des Istwertes für die Temperatur in der Reaktionskammer
- Stellglied 1 Mikrodosiersystem für Lösungsmittel (Wasser)
- Stellglied 2 Mikrodosiersystem für Präzipitant
- Stellglied 3 Mikrodosiersystem für Additive
- Stellglied 4 Gaszuleitung zur Änderung der Gaszusammensetzung
- Stellglied 5 Vorrichtung zum Heizen und zum Kühlen z.B. Peltierelement
- 1 Sollwert für die Temperatur in der Prozesskammer, Sollwert für die Luftfeuchtigkeit in der Prozesskammer, Sollwert für die Änderung der Molarität in Abhängigkeit der Zeit, Sollwert für die Änderung der Radienverteilung in der Probe Abhängigkeit der Zeit.
- 2 Istwert für die Radienverteilung in der Probe
- 3 Istwert für die Temperatur der Probe
- 4 Istwert für die Masse der Probe
- 5 Regelgröße für die Zugabe von Wasser
- 6 Regelgröße für die Zugabe von Präzipitant
- 7 Regelgröße für die Zugabe von Additiven
- 8 Istwert für die Luftfeuchtigkeit und die Gaszusammensetzung in der Prozesskammer
- 9 Istwert für die Temperatur in der Prozesskammer
- 10 Regelgröße für die Temperatur in der Prozesskammer
- 11 Regelgröße für die Luftfeuchtigkeit in der Prozesskammer

Im Folgenden wird ein Ausführungsbeispiel der Erfindung näher erläutert.

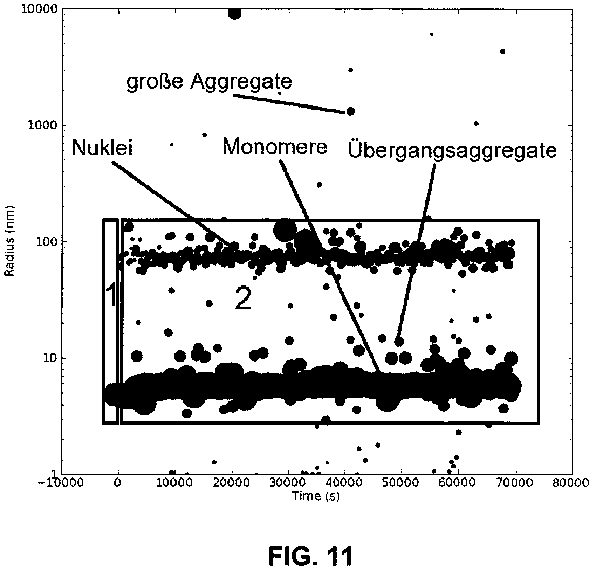

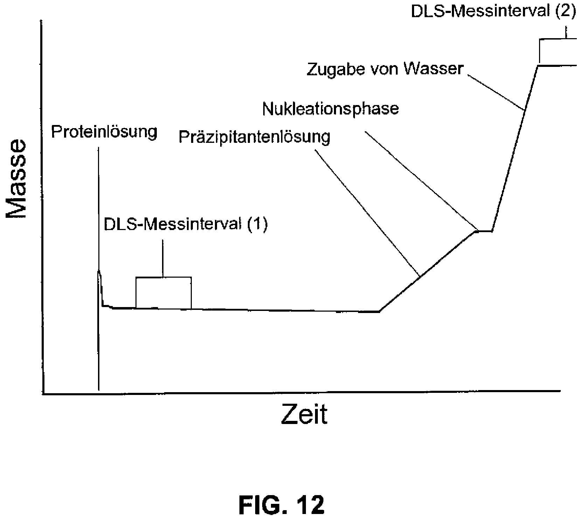

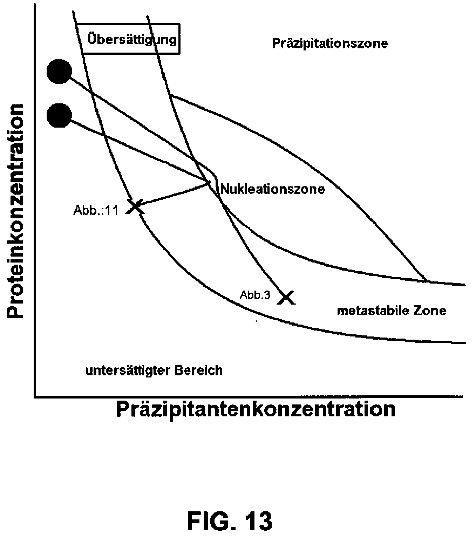

Im X-tal Controller kann der Übergang von der metastabilen Zone zur Präzipitationszone detektiert werden (Fig. 3 und 11). Fig. 3 zeigt die Größenzunahme der Nuklei. Dies ist ein Indikator für die Position im Phasendiagramm. Zunächst wurde in die Nukleationszone eingetaucht, zu erkennen an der Entstehung größerer Teilchen und diese nahmen sowohl in ihrer Anzahl, als auch in ihrer Größe zu. Mithilfe der Apparatur kann auch an verschiedenen Stellen im Phasendiagramm verweilt werden. Zu erkennen ist dies daran, dass kein Größenwachstum der Nuklei zu beobachten ist (Fig. 11 und 13). In Fig. 11 zeigt 1 die Größenverteilung vor Präzipitantenzugabe: Dort befindet sich das System in der untersättigten Zone des Phasendiagramms. 2 zeigt die Größenverteilung nach Präzipitantenzugabe. In Fig. 12 ist die zur DLS-Messung aus Fig. 11 zugehörige Gewichtskurve dargestellt, 1 und 2 stellen die beiden Zustände der Lösung 1 und 2 aus Fig. 11 dar. Das Protein und der Präzipiant wurden mit Wasser verdünnt. Die Stabilität der Nuklei ist typisch, wenn sich das System direkt auf der Löslichkeitskurve befindet (Phasengrenze zwischen untersättigter Lösung und der metastabilen Zone).

In Fig. 13 ist das Phasendiagram mit den mittels der erfindungsgemäßen Vorrichtung (X-tal Controller) bestimmten Punkten Fig. 3 und Fig. 11 zu sehen.

### Bezugszeichenliste zur Fig. 1

- 1: Prozesskammer (temperaturstabilisiert und gasdicht)
- 2: Mikrodosiereinheit
- 3: Messvorrichtung für dynamische Lichtstreuung
- 4: ultrasensitive Waage
- 5: Temperaturregelung
- 6: Feuchtigkeitsregelung
- 7: schwingungsgedämpftes Untergestell
- 8: Mikroskopobjektiv
- 9: Kamera
- 10: Probe
- 11: Probenhalter (in dies er Ausführung ein Deckgläschen)
- 12: Verschieb emechanik für Thermosensor und Beleuchtung
- 13: Beleu chtung mit Diffusor (in diesem Fall eine Weißlicht-LED)
- 14: Thermosensor
- 15: Sichtf enster
- 16: Steuerung der Gaszusammensetzung
- 17: Datenbank
- 18: PC zur Bedienung und Verbindung mit dem Internet und der Apparatur
- 19: Datenverbindun g

## Patentansprüche

1. Verfahren zur Kristallisation eines in einem Lösungsmittel gelösten Stoffs, nämlich Makromoleküls, mit den Schritten:
- Einbringen eines den Stoff enthaltenden Lösungsmittelvolumens in eine Kammer mit voreingestellter Temperatur, Luftfeuchtigkeit und Gaszusammensetzung,
- Zugeben eines vorbestimmten Volumens eines Präzipitanten zum den Stoff enthaltenden Lösungsmittelvolumen,
- Verdampfenlassen des Lösungsmittels bei gleichzeitigem Beobachten von Strukturänderungen im den Stoff und den Präzipitanten enthaltenden Lösungsmittelvolumen mittels dynamischer Lichtstreuung,
- Erfassen von Gewichtsänderungen und Bestimmen der Molaritäten,
- Zuordnen zum Ort im Phasendiagramm aufgrund der dynamischen Lichtstreuungs-Messung und der
Ergebnisse der Molaritätsbestimmung,
- Ausbildenlassen einer vorbestimmten Anzahl von Kristallisationskernen durch Hinzugeben von Lösungsmittel oder Hinzugeben von Präzipitant,
- Überführen des den Stoff und den Präzipitanten enthaltenden Lösungsmittelvolumens in einen metastabilen Zustand durch Zugeben von Lösungsmittel und/oder Proteinlösung oder durch Verringern lassen der Konzentration des gelösten Stoffs durch Ausbildenlassen von Nukleationskernen,
- Aufrechterhalten des metastabilen Zustands durch Hinzugeben einer vorbestimmten Menge des Stoffs zum den Stoff und den Präzipitanten enthaltenden Lösungsmittelvolumen oder Verdampfenlassen des Lösungsmittels bis wenigstens ein Kristall einer vorbestimmten Größe gebildet ist.

2. Verfahren nach Anspruch 1, **gekennzeichnet durch** den weiteren Schritt: Verdampfen lassen des Lösungsmittels bei gleichzeitigem Hinzufügen einer Gefrierschutzlösung mit einer den Lösungsmittelverlust kompensierenden Rate.

3. Verfahren nach einem der vorhergehenden Ansprüche, **dadurch gekennzeichnet, dass** das den Stoff enthaltende Lösungsmittelvolumen vor Zugeben des Präzipitanten durch Zugeben von Lösungsmittel konstant gehalten wird.

4. Vorrichtung zur Durchführung des Verfahrens nach einem der vorhergehenden Ansprüche,
**gekennzeichnet durch**
- eine Kammer mit Einrichtungen zum Einstellen einer in der Kammer herrschenden Temperatur, Luftfeuchtigkeit und Gaszusammensetzung,
- eine Pipettiervorrichtung zum Einbringen des den zu kristallisierenden Stoff enthaltenden Lösungsmittelvolumens in die Kammer;
- einen Probenhalter zur Aufnahme des den zu kristallisierenden Stoff enthaltenden Lösungsmittelvolumens,
- eine optische Vorrichtung mit mikroskopischer Auflösung zur Beobachtung des zu kristallisierenden Stoffs,
- eine Einrichtung zur dynamische Lichtstreuung zur Bestimmung der Molekülgrößenverteilung,
- eine Einrichtung zur statischen Lichtstreuung zur Messung der absoluten Streulichtintensität,
- einen Wärmestrahlungssensor zur Bestimmung von Reaktionsenthalpien,
- eine Mikrowaage zur präzisen Bestimmung der Molaritäten des Stoffs und/oder des Präzipitanten und deren Veränderungen,
- eine Mikrodosiereinrichtung für das Hinzugeben von Lösungen und Stoffen zum den zu kristallisierenden Stoff enthaltenden Lösungsmittelvolumen.

5. Vorrichtung nach Anspruch 4, **dadurch gekennzeichnet, dass** der Probenhalter ein Probenwechsler ist.

6. Vorrichtung nach einem der Anspruche 4 und 5, **dadurch gekennzeichnet, dass** die optische Vorrichtung ein mit einer Kamera versehenes Mikroskop ist.

7. Vorrichtung nach einem der Anspruche 4 bis 6, **dadurch gekennzeichnet, dass** die Mikrodosiereinrichtung zum Dosieren von Wasser, Präzipitant, Pufferlösung, Proteinlösung, Additiven, Gefrierschutzlösung, Quervernetzern, Liganden und Detergentien eingerichtet ist.

8. Vorrichtung nach einem der Ansprüche 4 bis 7, **dadurch gekennzeichnet, dass** eine Einrichtung zur Zugabe von Impfkristallen vorgesehen ist.

## Claims

1. A method for crystallising a substance, namely macromolecule, dissolved in a solvent, having the steps:
- introducing a volume of solvent containing the substance into a chamber with a pre-set temperature, atmospheric humidity and gas composition,
- adding a predetermined volume of a precipitant to the volume of solvent containing the substance,
- allowing the solvent to evaporate while simultaneously observing changes in structure in the volume of solvent containing the substance and the precipitant by means of dynamic light scattering,
- detecting weight changes and determining the molarities,
- associating with the location in the phase diagram on the basis of the dynamic light scattering measurement and the results of the determination of molarity,
- allowing a predetermined number of crystal nuclei to form by adding solvent or adding precipitant,
- converting the volume of solvent containing the substance and the precipitant into a metastable state by adding solvent and/or protein solution or by allowing the concentration of the dissolved substance to reduce by allowing nucleation cores to form,
- maintaining the metastable state by adding a predetermined quantity of the substance to the volume of solvent containing the substance and the precipitant or allowing the solvent to evaporate until at least one crystal of a predetermined size is formed.

2. A method according to Claim 1, **characterised by** the further step: allowing the solvent to evaporate while simultaneously adding an anti-freezing solution at a rate which compensates for the loss of solvent.

3. A method according to one of the preceding claims, **characterised in that** the volume of solvent containing the substance before addition of the precipitant is kept constant by adding solvent.

4. A device for carrying out the method according to one of the preceding claims, **characterised by**
- a chamber with means for setting a temperature, atmospheric humidity and gas composition which prevail in the chamber,
- a pipetting device for introducing the volume of solvent containing the substance to be crystallised into the chamber;
- a sample holder for receiving the volume of solvent containing the substance to be crystallised,
- an optical device with microscopic resolution for observing the substance to be crystallised,
- a means for dynamic light scattering for determining the molecule size distribution,
- a means for static light scattering for measuring the absolute scattered light intensity,
- a thermal radiation sensor for determining reaction enthalpies,
- a microchemical balance for precisely determining the molarities of the substance and/of the precipitant and the changes thereto,
- a microdosing means for adding solutions and substances to the volume of solvent containing the substance to be crystallised.

5. A device according to Claim 4, **characterised in that** the sample holder is a sample changer.

6. A device according to one of Claims 4 and 5, **characterised in that** the optical device is a microscope provided with a camera.

7. A device according to one of Claims 4 to 6, **characterised in that** the microdosing means is set up for dosing water, precipitant, buffer solution, protein solution, additives, anti-freezing solution, cross-linkers, ligands and detergents.

8. A device according to one of Claims 4 to 7, **characterised in that** a means for adding seed crystals is provided.

## Revendications

1. Procédé de cristallisation d'une substance dissoute dans un solvant, à savoir d'une macromolécule, comprenant les étapes suivantes :
- introduction d'un volume de solvant contenant la substance dans une chambre dont la température, l'humidité de l'air et la composition gazeuse sont préréglées,
- ajout d'un volume prédéfini d'un agent de précipitation au volume de solvant contenant la substance,
- évaporation du solvant tout en observant les modifications de structure dans le volume de solvant contenant la substance et l'agent de précipitation au moyen de diffusion lumineuse dynamique,
- saisie des variations de poids et détermination des molarités,
- attribution d'une position dans le diagramme de phase sur la base de la mesure de la diffusion lumineuse dynamique et des résultats de la détermination de la molarité,
- formation d'un nombre prédéfini de noyaux cristallins par ajout de solvant ou par ajout d'agent de précipitation,
- passage du volume de solvant contenant la substance et l'agent de précipitation dans un état métastable par ajout de solvant et/ou d'une solution de protéines ou par diminution de la concentration de la substance dissoute par formation de noyaux de nucléation ;
- maintien de l'état métastable par ajout d'une quantité prédéfinie de la substance au volume de solvant contenant la substance et l'agent de précipitation ou par évaporation du solvant jusqu'à ce qu'au moins un cristal d'une taille prédéfinie soit formé.

2. Procédé selon la revendication 1, **caractérisé par** l'étape supplémentaire : évaporation du solvant tout en ajoutant simultanément une solution antigel à une vitesse qui compense la perte en solvant.

3. Procédé selon l'une des revendications précédentes, **caractérisé en ce que** le volume de solvant contenant la substance est maintenu constant par ajout de solvant avant l'ajout de l'agent de précipitation.

4. Dispositif pour la mise en oeuvre du procédé selon l'une des revendications précédentes,
**caractérisé par**
- une chambre avec des installations pour régler une température, une humidité de l'air et une composition gazeuse régnant dans la chambre,
- un dispositif de pipetage pour ajouter dans la chambre le volume de solvant contenant la substance à cristalliser,
- un support d'échantillons pour recevoir le volume de solvant contenant la substance à cristalliser,
- un dispositif optique avec une résolution microscopique pour observer la substance à cristalliser,
- une installation pour la diffusion lumineuse dynamique pour déterminer la répartition dimensionnelle des molécules,
- une installation pour la diffusion lumineuse statique pour mesurer l'intensité absolue de la lumière diffusée,
- un capteur de rayonnement thermique pour déterminer l'enthalpie de réaction,
- une microbalance pour déterminer de façon précise les molarités de la substance et/ou de l'agent de précipitation et leurs modifications,
- une installation de microdosage pour l'ajout de solutions et de substances au volume de solvant contenant la substance à cristalliser.

5. Dispositif selon la revendication 4, **caractérisé en ce que** le support d'échantillons est un changeur d'échantillons.

6. Dispositif selon l'une des revendications 4 et 5, **caractérisé en ce que** le dispositif optique est un microscope muni d'une caméra.

7. Dispositif selon l'une des revendications 4 à 6, **caractérisé en ce que** l'installation de microdosage est réglée pour doser de l'eau, un agent de précipitation, une solution tampon, une solution de protéines, des additifs, une solution antigel, des agents de réticulation, des ligands et des détergents.

8. Dispositif selon l'une des revendications 4 à 7, **caractérisé en ce qu'**il est prévu une installation pour l'ajout de germes de cristallisation.
